Europäisches Patentamt

European Patent Office

Office européen des brevets

(11) Veröffentlichungsnummer: **0 463 687 A2**

# EUROPÄISCHE PATENTANMELDUNG

(21) Anmeldenummer: **91201531.0**

(22) Anmeldetag: **18.06.91**

(51) Int. Cl.5: **H03K 17/735**

(30) Priorität: **22.06.90 DE 4019928**

(43) Veröffentlichungstag der Anmeldung:
**02.01.92 Patentblatt 92/01**

(84) Benannte Vertragsstaaten:
**AT DE FR GB**

(71) Anmelder: **Philips Patentverwaltung GmbH**
**Wendenstrasse 35 Postfach 10 51 49**
**W-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB AT**

(72) Erfinder: **Kersten, Reinhard, Dr.**
**Meischenfeld 29**
**W-5100 Aachen(DE)**
Erfinder: **Sonnek, Martin**
**Schützenstrasse 44**
**A-9300 St. Veit/GL(AT)**

(74) Vertreter: **Kupfermann, Fritz-Joachim,**
**Dipl.-Ing. et al**
**Philips Patentverwaltung GmbH**
**Wendenstrasse 35 Postfach 10 51 49**
**W-2000 Hamburg 1(DE)**

(54) **Schaltungsanordnung zur netzrückwirkungsarmen Leistungssteuerung.**

(57) Die Erfindung betrifft eine Schaltungsanordnung (10) zur netzrückwirkungsarmen Leistungssteuerung mindestens zweier ohmscher Lasten (11, 12) mit Leistungshalbleitern, Schaltelementen (30) und einer Ansteuereinheit zur Beeinflussung der Leistungsaufnahme der Lasten (11, 12). Um internationale Standards zur Vermeidung von Netzrückwirkungen beim Schalten größerer Lasten einzuhalten, wird eine einfache und somit preisgünstige Schaltung angegeben, die auch für kleinere Hausgeräte, wie Lichtkochherde, Bügeleisen, Kochtöpfe etc. geeignet ist, bei der die Ansteuereinheit eine Leistungshalbleitereinheit (13) für zwei Schaltrichtungen steuert und über die Schaltelemente (30) eine oder beide Lasten (11, 12) mit der einzigen Leistungshalbleitereinheit (13) verschaltet.

FIG.1

Die Erfindung betrifft eine Schaltungsanordnung zur netzrückwirkungsarmen Leistungssteuerung mindestens zweier ohmscher Lasten mit Leistungshalbleitern, Schaltelementen und einer Ansteuereinheit zur Beeinflussung der Leistungsaufnahme der Lasten.

Beim Steuern und auch beim Regeln von Lampen, insbesondere Halogenlampen, deren Kaltwiderstand sehr niedrig ist und deren Ein- und Hochschaltströme sehr hoch sind, ergeben sich dadurch Probleme, daß beim Schalten der Lampen Rückwirkungen auf das Stromversorgungsnetz auftreten. Für eine Leistungssteuerung derartiger Lampen mit einer Abstufung der Leistungsaufnahme ist es bekannt, zwischen den Hauptleistungsstufen, z.B. einer Parallel, Serien- und Ausschaltung zweier Lampen, hin und her zu schalten bzw. die Hauptleistungsstufen jeweils für nur bestimmte Zeiten einzuschalten. Beim Ein- und Ausschalten der Lasten entstehen allerdings unangenehme Schaltstöße, die entsprechende Netzspannungsschwankungen auslösen.

Auf derartige Netzspannungsschwankungen reagiert das menschliche Auge insbesondere in einem Frequenzbereich bei ca. 10 Hz sehr empfindlich. Es gibt daher für entsprechende Geräte Vorschriften zur Einhaltung genügend kleiner Schaltstöße, etwa den IEC Standard 555 "Disturbance in supply systems caused by houshold appliances and similar electrical equipment". In diesem Standard ist im wesentlichen festgelegt, welcher Oberwellengehalt oberhalb von 50 Hz und welche Netzspannungsschwankungen unterhalb von 50 Hz ausgelöst werden dürfen, um unangenehmes sogenanntes Flickern zu vermeiden.

Konkret ergibt sich hieraus, daß eine Leistungssteuerung mit kurzen Schaltzeiten zwischen den Hauptleistungsstufen für große Lasten, z.B. 1000 W nicht mehr möglich ist, da dann die resultierenden Netzspannungsschwankungen nicht mehr zulässig sind.

Es ist somit nicht möglich, Lampen größerer Leistung direkt im Serien- oder Parallelbetrieb beispielsweise automatisch hochzufahren. Ferner ist zur Reduktion der Leistung unter die Leistung bei Versorgungsspannung und Serienbetrieb der Lampen eine Reduktion der Versorgungsspannung nötig. Üblicherweise werden hierzu Schaltnetzteile verwendet, die allerdings sehr aufwendig und teuer sind. Eine weitere Möglichkeit besteht darin, daß einzelne Phasen der Versorgungsspannung ausgelassen werden, was jedoch wiederum zu starken Netzrückwirkungen führen kann.

Aus der deutschen Offenlegungsschrift 37 26 535 ist ein Verfahren zur schaltstoßarmen Leistungssteuerung elektrischer Lasten bekannt, bei dem eine aufwendige Schaltungsanordnung mit drei Triacs bzw. sechs Thyristoren verwendet wird.

Diese Anordnung läßt z.B. bei zwei Lasten die Steuerung mit verschiedenen Schalt-Moden zu, und zwar in der Ansteuerung beider Lasten einzeln, parallel oder hintereinander. Diese Schaltungsanordnung benötigt eine aufwendige und somit teure Ansteuerelektronik für die Vielzahl der eingesetzten Leistungshalbleiter und ist durch Selbstzündung der Leistungshalbleiter und somit der Zerstörung dieser gefährdet.

Für den Ausdruck Schalt-Moden werden nachfolgend auch die Ausdrücke Schaltzustände und Netzhalbwellenmuster gleichbedeutend benutzt.

Der Erfindung liegt die Aufgabe zugrunde, eine Schaltungsanordnung zur netzrückwirkungsarmen Leistungssteuerung zu schaffen, die technisch einfach aufgebaut ist und somit den wirtschaftlichen Einsatz in kleineren Geräten, wie Lichtkochherden, Bügeleisen, Kochtöpfen etc. ermöglicht.

Diese Aufgabe wird erfindungsgemäß dadurch gelöst, daß die Ansteuereinheit eine Leistungshalbleitereinheit für zwei Schaltrichtungen steuert und über die Schaltelemente eine oder beide Lasten mit der einzigen Leistungshalbleitereinheit verschaltet.

Gemäß einer vorteilhaften Ausgestaltung der Erfindung ist die Leistungshalbleitereinheit einerseits mit Masse verbunden und andererseits mit der einen Last und über die Schaltelemente mit der anderen Last.

Gemäß einer vorteilhaften Ausgestaltung der Erfindung kann die Leistungshalbleitereinheit aus einem Triac oder aus zwei gegenpolig geschaltete Thyristoren gebildet sein und die Schaltelemente können durch ein einziges Relais mit einem ersten und einem zweiten Umschalter aufgebaut sein.

Gemäß einer bevorzugten Ausgestaltung der Erfindung kann die Leistungshalbleitereinheit in Ruhestellung des Relais über eine Last, eine Verbindungsleitung, den zweiten Umschalter und über die andere Last mit der Versorgungsspannung verbunden sein. In der Arbeitsstellung des Relais kann die Leistungshalbleitereinheit über die eine Last und den ersten Umschalter des Relais mit der Versorgungsspannung verbunden sein und die andere Last parallel zu diesem Zweig geschaltet sein.

Gemäß einer weiteren bevorzugten Ausgestaltung der Erfindung kann mittels der Schaltelemente eine Reihenschaltung aus der Leistungshalbleitereinheit und einer Parallelschaltung der beiden Lasten realisiert werden.

Gemäß einer weiteren bevorzugten Ausgestaltung der Erfindung können die Schaltelemente, die durch ein Relais gebildet sind, die in Abhängigkeit der Ansteuerelektronik Lasten in Reihe und parallel schalten, wobei die Leistungshalbleitereinheit für jede Schaltrichtung aufgeteilt jeweils einer Last zugeordnet ist und im Parallelbetrieb beider Lasten der entsprechende Teil der Leistungshalbleitereinheit einseitig mit Massepotential verbunden ist und aus einer Diode und einem Thyristor aufgebaut ist.

Gemäß einer weiteren bevorzugten Ausgestaltung der Erfindung können die Schaltelemente, die aus einem Relais gebildet sind, die in Abhängigkeit der Ansteuerelektronik Lasten in Reihe und parallel schalten, wobei die Leistungshalbleitereinheit zwischen der Versorgungsspannung und einer der Lasten angeordnet und aus einem Triac oder zwei gegenpolig geschaltete Thyristoren aufgebaut ist.

Vorteilhaft kann in der Verbindung zwischen den Kontakten der Umschalter des Relais ein Heißleiter zur Begrenzung kurzzeitig auftretender Einschaltströme angeordnet sein.

Gemäß einer bevorzugten Ausgestaltung der Erfindung kann die Ansteuereinheit als Logikbaustein und dieser als Mikroprozessor o.dgl. ausgebildet sein und zum quasi rückwirkungsfreien Steuern der Leistungsaufnahme die Schaltungsanordnung in verschiedene Schaltzustände versetzen. Vorteilhafte Schaltzustände sind:

a) Der Parallelbetrieb beider Lasten,

b) der Betrieb nur einer Last mit Versorgungsspannung,

c) der Betrieb der einen Last mit Versorgungsspannung und der anderen Last im 2/3-, 1/3- oder 1/5-Phasenbetrieb,

d) der Betrieb wie c) mit gepulsten Phasen,

e) der Serienbetrieb beider Lasten mit Versorgungsspannung,

f) beide Lasten in Serie mit 2/3-, 1/3- oder 1/5-Phasenbetrieb,

g) der Betrieb wie f) mit gepulsten Phasen,

h) der "Aus"-Betrieb beider Lasten,

i) der Betrieb einer Last mit Versorgungsspannung und verzögerten Hinzuschalten der anderen Last, auch im 1/3- und 2/3-Phasenbetrieb, und

j) der Betrieb beider Lasten 11 und 12 im 2/3- oder 1/3-Phasenbetrieb.

Hier sei angemerkt, daß die Zustände h) und der jeweilige Phasen-Betrieb durch entsprechende Sperrung der Leistungshalberleitereinheit hervorgerufen wird.

Ein besonders rückwirkungsfreies Einschalten kann vorteilhaft dadurch gegegeben sein, daß die Ansteuereinheit nacheinander die Schaltzustände f), e) und a) erzeugt. Der letztgenannte Schaltzustand kann auch durch einen Schaltzustand i) oder j) ersetzt werden, bei dem eine Last mit Versorgungsspannung und die andere Last über die Leistungshalbleitereinheit verzögert hinzugeschaltet wird. Hierdurch ist ein stromloses Umschalten des Relais möglich. Besonders vorteilhaft ist dieses Einschalten gegenüber Möglichkeiten mit Phasenanschnitt, da es einfacher ist und keine teuren Entstörmaßnahmen gegen Funkstörungen erforderlich macht.

Die erfindungsgemäße Schaltungsanordnung mit nur einem Relais und nur einer Leistungshalbleitereinheit ist gegenüber den bekannten Schaltungen besonders einfach aufgebaut und erlaubt äußerst rückwirkungsfreies Einschalten, Hochregeln und Rückregeln von beispielsweise zwei Lampen größerer Leistung. Bei Fehlfunktionen der Ansteuereinheit ist die Halbleitereinheit gegen Zerstörung geschützt. Durch die Vielzahl der möglichen Schaltzustände und den Puls-Betrieb sind auch kleinste Leistungen steuerbar. Durch die Anordnung der Leistungshalbleitereinheit gegen Masse ist eine einfache galvanisch gekoppelte Aussteuerung der Leistungshalbleitereinheit ohne Hochvolttransistor und Schutzdioden möglich. Durch ein galvanisch gekoppeltes Nullpunkt-Steuersignal der Steuereinheit kann die Leistungssteuereinheit zuverlässig im frühestmöglichen Moment ohne Einfluß der Last gezündet werden.

Wenn die Leistungshalbleitereinheit nur mit einer Last in Reihe liegt, ergibt sich ferner eine Reduzierung der Wärmeverlustleistung. Ein weiterer Vorteil ergibt sich dadurch, daß bei Steuerung der Ansteuereinheit die Lasten über die Ruhekontakte des Relais in Serie liegen, was zu günstigen Fehlerbedingungen führt, da dadurch die maximal mögliche Leistung nicht auftreten kann. Ferner sei darauf hingewiesen, daß durch die Möglichkeit von getrennt schaltbaren Umschaltern des Relais weitere Schaltzustände möglich sind.

Weitere bevorzugte Ausgestaltungen der Erfindung ergeben sich aus den Unteransprüchen.

Ein Ausführungsbeispiel wird nachfolgend unter Bezugnahme auf eine Zeichnung näher erläutert. Darin zeigt:

Fig. 1    eine erfindungsgemäße Schaltungsanordnung, die eine Reihenschaltung beider Lasten und den Betrieb nur einer Last ermöglicht, sowie ein Zuschalten der anderen Last mit beliebigen Schaltzuständen,

Fig. 2    eine Modifikation von Fig. 1, die eine Reihen- und Parallelschaltung beider Lasten bei beliebigen Schaltzuständen ermöglicht,

Fig. 3    eine Schaltungsanordnung nach Fig. 1 mit modifizierter Leistungshalbleitereinheit,

Fig. 4    eine Schaltungsanordnung nach Fig. 1 mit aufgeteilter und modifizierter Leistungshalbleitereinheit,

Fig. 5    eine Schaltungsanordnung nach Fig. 1 mit einer Leistungshalbleitereinheit zwischen Versorgungsspannung und einer Last,

Fig. 6    den prinzipiellen Spannungsverlauf im 1/3-Phasenbetrieb,

Fig. 7    den prinipiellen Phasenverlauf im gepulsten 1/3-Phasenbetrieb,

Fig. 8 den prinzipiellen Spannungsverlauf im 2/3-Phasenbetrieb, und

Fig. 9 schematisch einen netzrückwirkungsarmen Einschalt-/Hochschaltzyklus auf Maximalleistung.

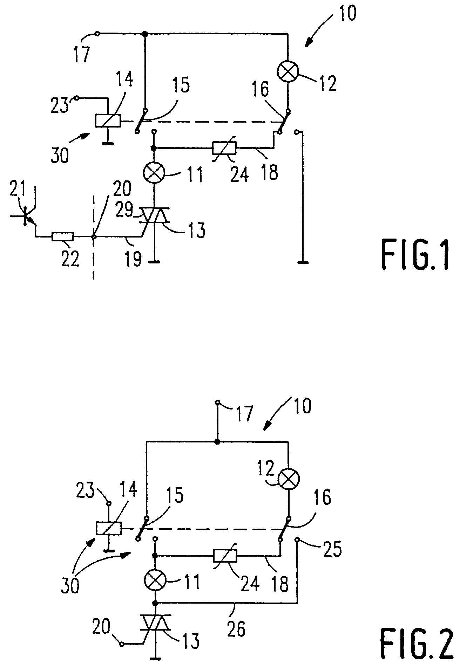

Fig. 1 zeigt eine erfindungsgemäße Schaltungsanordnung 10 zur netzrückwirkungsarmen Leistungssteuerung mindestens zweier ohmscher Lasten 11, 12 zur Beeinflussung der Leistungsaufnahme der Lasten 11, 12, wobei diese vorzugsweise Lampen größerer Leistung sind. Die Schaltungsanordnung 10 wird von einer nicht dargestellten Ansteuereinheit angesteuert und weist eine Leistungshalbleitereinheit 13 für zwei Schaltrichtungen und Schaltelemente 30 auf. Die Schaltelemente 30 werden bevorzugt durch ein einziges Relais 14 mit einem ersten Umschalter 15 und einem zweiten Umschalter 16 gebildet.

Der erste Umschalter 15 verbindet in Arbeitsstellung den Anschlußpunkt 17 der Phase einer Versorgungsspannung zunächst mit der ersten Last 11, welcher die Leistungshalbleitereinheit 13 nachgeordnet ist. In Arbeitsstellung verbindet der zweite Umschalter 16 den Anschlußpunkt 17 und die nachgeordnete zweite Last 12 mit Massepotential. In Ruhestellung der Umschalter 15 und 16 ist die zweite Last 12 über den entsprechenden Ruhekontakt des Umschalters 16 und eine Verbindungsleitung 18 mit der ersten Last 11 verbunden, an die sich ausgangsseitig, wie bereits beschrieben, die Leistungshalbleitereinheit 13 anschließt, welche ebenfalls an Massepotential angeschlossen ist.

Der Steueranschluß 19 der Leistungshalbleitereinheit 13 erhält über eine Anschlußklemme 20 ein von beispielsweise einem Logikbaustein, der als Mikroprozessor ausgebildet ist, herrührendes Ansteuersignal, das beispielsweise mit einem Transistor 21 und einem Widerstand 22 aufbereitet sein kann. Das Signal an der Basis des Transistors 21 kann hierzu ein Rechtecksignal sein. Die nichtdargestellte Ansteuereinheit, die ein Mikroprozessor, aber auch eine andere Logikschaltung sein kann, steuert über eine Klemme 23 auch das Relais 14 und somit die Schaltelemente 30 an.

Besonders vorteilhaft kann in der Verbindungsleitung 18 ein Heißleiter 24 vorgesehen sein, um zu hohe kurzzeitig auftretende Einschaltströme zu begrenzen.

Die Ansteuereinheit ist nun derart ausgebildet, daß zum quasi rückwirkungsfreien Steuern der Leistungsaufnahme der Lasten 11 und 12 die Schaltungsanordnung 10 in verschiedene Schaltzustände versetzt werden kann. Abhängig von der Stellung der Umschalter 15 und 16 und von der Ansteuerung der Leistungshalbleitereinheit 13 sind die folgenden vorteilhaften Schaltzustände schaltbar:

a) Parallelbetrieb beider Lasten 11 und 12,

b) Betrieb nur einer Last 12 mit Versorgungsspannung,

c) Betrieb der einen Last 12 mit Versorgungsspannung und Betrieb der anderen Last 11 im 1/3-, 2/3- oder 1/5-Phasen-Betrieb,

d) Betrieb wie unter c) mit gepulsten Phasen,

e) Serienbetrieb beider Lasten 11, 12 mit Versorgungsspannung,

f) Betrieb beider Lasten 11, 12 in Serie mit 1/3-, 2/3- oder 1/5-Phasenbetrieb,

g) Betrieb wie unter f) mit gepulsten Phasen,

h) "Aus"-Betrieb beider Lasten 11 und 12,

i) der Betrieb der einen Last 12 mit Versorgungsspannung und verzögert hinzugeschalteter anderer Last 11, auch im 1/3- und 2/3-Phasenbetrieb, und

j) der Betrieb beider Lasten 11 und 12 im 2/3- oder 1/3-Phasenbetrieb.

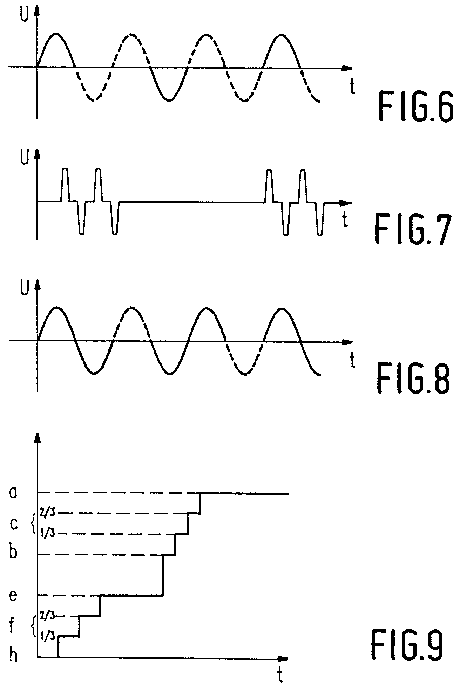

Hier sei angemerkt, daß die Zustände h) und der jeweilige Phasenbetrieb durch entsprechende Sperrung der Leistungshalbleitereinheit 13 hervorgerufen wird, wie dies weiter unten bei der Beschreibung der Fig. 6, 7 und 8 näher erläutert ist. Ferner sei angemerkt, daß das Massenpotential das Potential des Mittelpunktleiters eines Drehstromversorgungsnetzes sein kann.

Fig. 2 zeigt eine Schaltungsvariante der Schaltung 10 entsprechend Fig. 1. Bei dieser Variante ist der in Arbeitsstellung des Umschalters 16 durchgeschaltete Arbeitskontakt 25 nicht wie in Fig. 1 mit Massepotential, sondern über eine Leitung 26 mit der Leistungshalbleitereinheit 13 derart verbunden, daß in Arbeitsstellung der Schaltelemente 30, bzw. des Relais 14 und der Schaltkontakte 15 und 16 eine Reihenschaltung aus der Leistungshalbleitereinheit 13 und einer Parallelschaltung aus der Last 11 und der Last 12 entsteht.

Besonders vorteilhaft bei dieser Schaltungsvariante ist, daß während des Umschaltens von Ruhe- in Arbeitsstellung des Relais 14 und umgekehrt beide Lasten 11 und 12 stromlos geschaltet werden können. Ausgehend davon, daß das Relais 14 über die Ansteuerelektronik jeweils im Nulldurchgang der Versorgungsspannung umgeschaltet werden kann und der Stromfluß wegen der benötigten Schaltzeit und dem Prellen des Relais 14 für eine bis zwei Halbwellen über die Leistungshalbleitereinheit 13 unterbrochen werden kann, läßt sich somit mit dieser Schaltungsvariante ein äußerst schonendes Schalten des Relais 14 erzeugen, wodurch der Einsatz von einfachen und somit preisgünstigen Relais möglich wird. Bei dieser Variante ist allerdings eine höhere Verlustleistung in der Leistungshalbleitereinheit 13 hinzunehmen, da im Parallelbetrieb der Lasten 11 und 12 der Gesamtstrom über die Leistungshalbleitereinheit 13 fließt. Die Leistungshalbleitereinheit 13 in den Fig. 1 und 2 ist bevorzugt aus einem Triac 29 aufgebaut.

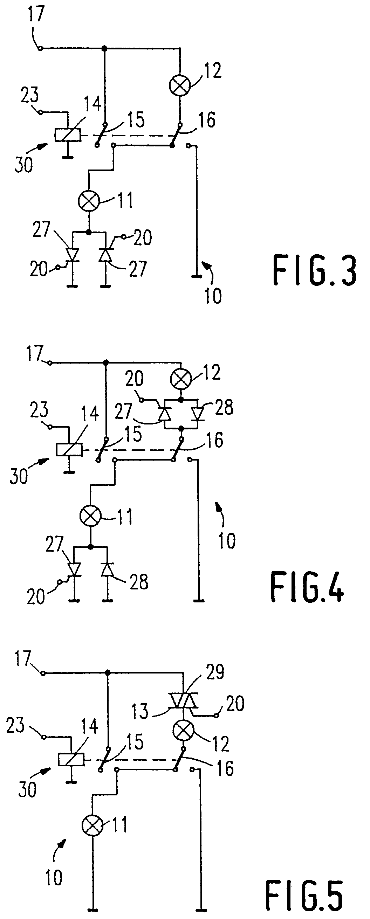

In den Fig. 3, 4 und 5 sind verschiedene Varianten der Schaltungsanordnung 10 aus Fig. 1 hinsichtlich der Art und Anordnung der Leistungshalbleitereinheit 13 gezeigt. Im einzelnen zeigt Fig. 3 den Aufbau der entsprechend Fig. 1 aus einem Triac 29 aufgebauten Leistungshalbleitereinheit 13, durch zwei gegenpolig geschaltete Thyristoren 27, wodurch wiederum beide Schaltrichtungen möglich sind.

Aus Fig. 4 geht eine Aufteilung der Leistungshalbleitereinheit 13 hervor. Jeder der beiden Teile ist mit einem Thyristor 27 und einer gegenpolig geschalteten Diode 28 für eine Schaltrichtung schaltbar ausgelegt und jeweils der einen Last 11 und der anderen Last 12 nachgeordnet. Bei dieser Variante ist besonders vorteilhaft, daß auch hier eine Zerstörung der Halbleiterbauteile durch Selbstzündung sicher vermieden ist.

Fig. 5 zeigt eine weitere Variante der Schaltungsanordnung nach Fig. 1, wobei wieder ein Triac 29 die Leistungshalbleitereinheit 13 bildet, jedoch zwischen dem Anschlußpunkt 17 und der Last 12 angeordnet ist.

Für die zuverlässige Zündung der Halbleiterelemente der Leistungshalbleitereinheit 13 ist bei allen erfindungsgemäßen Schaltungsvarianten auch dadurch gesorgt, daß diese im frühestmöglichen Moment ohne Einfluß der Lasten 11 und 12 durch ein galvanisch gekoppeltes Nullpunkt-Steuersignal erfolgen kann. Hier sei angemerkt, daß die Zündspannung bei Halbleiterelementen lastabhängig ist, was bei kurzen Zündimpulsen, ggf. seitens der Steuerung zu Verschiebungen der Zündimpulse führt. Eine relativ späte, speziell galvanisch getrennte Zündung führt dann zu Funkstörungen und erfordert zusätzliche konstruktive Gegenmaßnahmen.

Ferner sei darauf hingewiesen, daß selbstverständlich die Umschalter 15 und 16 getrennt schaltbar ausgestaltet sein können, wodurch weitere Schaltzustände möglich werden, was üblicherweise für Wärmegeräte allerdings nicht notwendig ist.

In Fig. 6 ist der prinzipielle Spannungsverlauf U im 1/3-Phasenbetrieb längs der Zeitachse t dargestellt. Auf eine eingeschaltete Halbwelle, die mit einem ausgezogenen Strich dargestellt ist, folgen jeweils zwei ausgeschaltete Halbwellen, die gestrichelt dargestellt sind. In analoger Weise ist der 1/5-Phasenbetrieb, der nicht dargestellt ist, zusammengesetzt.

Fig. 7 zeigt den gepulsten Spannungsverlauf U entsprechend dem 1/3-Phasenbetrieb aus Fig. 6, allerdings mit einem anderen Maßstab auf der Zeitachse t. Mit beispielsweise einer Einschaltpulsbreite von größer/gleich 300 msec und einer Ausschaltpulsbreite von einigen 10 msec bis zu einigen Sekunden können beispielsweise zwei Halogenlampen mit je 1000 W betrieben werden, wobei der eingangs genannte Standard IEC 555 eingehalten wird.

Fig. 8 zeigt entsprechend Fig. 6 den prinzipiellen Spannungsverlauf U in 2/3-Phasenbetrieb längs der Zeitachse t. Auf zwei eingeschaltete Halbwellen, die mit einem ausgezogenen Strich dargestellt sind, folgt eine ausgeschaltete Halbwelle, die gestrichelt dargestellt ist.

Fig. 9 zeigt auf der Ordinate die Leistungsaufnahme in Abhängigkeit der Zeit t für einen weichen Einschalt-/Hochschaltzyklus von Null auf Maximalleistung, welcher üblicherweise die geringsten Rückwirkungen auf die Versorgungsspannung zeigt.

Der Schaltzustand h) entspricht der Leistungsstufe 0 und der Schaltzustand a) der Maximalleistung. Als Einschaltdauer für die einzelnen Schaltzustände können für Zustand f) 120 ms, jeweils zur Hälfte im 1/3- und 2/3-Phasenbetrieb und für Zustand e) 180 ms vorgesehen sein. Das weitere Hochschalten bis zur Schaltstufe a) mit beispielsweise zwei Lasten 11 und 12 mit je 1000 W kann für die beiden Schaltungsvarianten in Fig. 1 und 2 unterschiedlich ablaufen.

Bei Fig. 1 erfolgt die Umschaltung des Relais 14 innerhalb ca. 20 ms und es steht der Zustand b) für weitere 60 ms an, während nur die Last 12 an der Versorgungsspannung ist. Anschließend kann für 120 ms der Zustand c) vorgesehen sein zusätzlich mit Last 11 jeweils zur Hälfte im 1/3- und 2/3-Phasenbetrieb.

Bei Fig. 2 erfolgt ebenfalls zunächst die Umschaltung des Relais 14 innerhalb ca. 20 ms mit ausgeschalteter Leistungshalbleitereinheit 13. Anschließend erfolgt für einen weichen Übergang der Betrieb beider Lasten 11, 12 in Zustand j) und zwar für 30 ms der 1/3- und für weitere 30 ms der 2/3-Phasenbetrieb parallel.

Bei den vorangehend beschriebenen Schaltzuständen bis zum Zustand a) können auch Zwischenstufen weggelassen werden. Dies erhöht allerdings die Netzrückwirkung.

Weitere Leistungsstufen, z.B. entsprechend den Schaltzuständen c) und d) mit Leistungen zwischen der Maximal- und der halben Leistung oder entsprechend g) mit kleinsten Leistungen durch beliebig wählbares Pulsverhältnis zwischen ca. 5 % und 15 % der Maximalleistung sind für Wärmegeräte als Warmhaltestufe durchaus denkbar.

Ein weiterer nicht dargestellter vorteilhafter Einschalt-Hochlaufzyklus ergibt sich durch die Aufeinanderfolge der Schaltzustände f), e) und a). Der letztgenannte Schaltzyklus a) kann hierbei auch durch den Schaltzustand i) oder j) ersetzt werden.

Die hier besprochenen Einschaltzyklen erfordern im Vergleich zu einem Phasenanschnittsverfahren keine teuren Funkentstörmaßnahmen und sind ausreichend sanft, um Netzrückwirkungen vorzüglich klein zu halten.

Die in der vorstehenden Beschreibung, in den Fig. sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

**Patentansprüche**

1. Schaltungsanordnung zur netzrückwirkungsarmen Leistungssteuerung mindestens zweier ohmscher Lasten mit Leistungshalbleitern, Schaltelementen und einer Ansteuereinheit zur Beeinflussung der Leistungsaufnahme der Lasten,
dadurch gekennzeichnet, daß die Ansteuereinheit eine Leistungshalbleitereinheit (13) für zwei Schaltrichtungen steuert und über die Schaltelemente (30) eine oder beide Lasten (11, 12) mit der einzigen Leistungshalbleitereinheit (13) verschaltet.

2. Schaltungsanordnung nach Anspruch 1,
dadurch gekennzeichnet, daß die Leistungshalbleitereinheit (13) einerseits mit Massepotential verbunden ist und andererseits mit der einen Last (11) und über die Schaltelemente (30) mit der anderen Last (12).

3. Schaltungsanordnung nach Anspruch 2,
dadurch gekennzeichnet, daß die Leistungshalbleitereinheit (13) aus einem Triac (29) oder zwei gegenpolig geschalteten Thyristoren (27) gebildet ist und als Schaltelemente (30) ein einziges Relais (14) mit einem ersten und einem zweiten Umschalter (15, 16) vorgesehen ist.

4. Schaltungsanordnung nach Anspruch 3,
dadurch gekennzeichnet, daß die Leistungshalbleitereinheit (13) in Ruhestellung des Relais (14) über die eine Last (11), eine Verbindungsleitung (18), den zweiten Umschalter (16) und die andere Last (12) mit dem Anschlußpunkt (17) der Phase der Versorgungsspannung verbunden ist, und daß die Leistungshalbleitereinheit (13) in der anderen Stellung des Relais (14) über die eine Last (11) und den ersten Umschalter (15) mit dem Anschlußpunkt (17) verbunden ist und die andere Last (12) parallel zu diesem Zweig geschaltet ist.

5. Schaltungsanordnung nach Anspruch 3,
dadurch gekennzeichnet, daß die Leistungshalbleitereinheit (13) in Ruhestellung des Relais (14) über die eine Last (11), eine Verbindungsleitung (18), den zweiten Umschalter (16) und die andere Last (12) mit dem Anschlußpunkt (17) der Phase der Versorgungsspannung verbunden ist, und daß die Leistungshalbleitereinheit (13) in der anderen Stellung des Relais (14) über die eine Last (11) und den ersten Umschalter (15) mit dem Anschlußpunkt (17) verbunden ist und die andere Last (12) über den Arbeitskontakt (25) des zweiten Umschalters (16) und eine Verbindung (26) parallel zur ersten Last (11) geschaltet ist.

6. Schaltungsanordnung nach Anspruch 1,
dadurch gekennzeichnet, daß ein Relais (14) mit zwei Umschaltern (15, 16) die Schaltelemente (30) bildet und die Lasten (11, 12) in Abhängigkeit der Ansteuereinheit in Reihe und parallel schaltet und die Leistungshalbleitereinheit (13) für jede Schaltrichtung aufgeteilt jeweils einer der Lasten (11, 12) zugeordnet ist, wobei im Parallelbetrieb beider Lasten (11, 12) der jeweilige Teil der Leistungshalbleitereinheit (13) einerseits mit Massepotential verbunden ist und aus einer gegenpolig geschalteten Diode (28) und einem Thyristor (27) aufgebaut ist.

7. Schaltungsanordnung nach Anspruch 1,
dadurch gekennzeichnet, daß ein Relais (14) mit zwei Umschaltern (15, 16) die Schaltelemente (30) bildet und in Abhängigkeit der Ansteuereinheit die Lasten (11, 12) in Reihe und parallel schaltet und die Leistungshalbleitereinheit (13) einerseits mit einem Anschlußpunkt (17) der Phase der Versorgungsspannung und einer der Lasten (12) angeordnet ist und aus einem Triac (29) oder zwei gegenpolig geschalteten Thyristoren (27) aufgebaut ist.

8. Schaltungsanordnung nach einem oder mehreren der vorhergehenden Ansprüche,
dadurch gekennzeichnet, daß in der Verbindung (18) zwischen dem Arbeitskontakt des ersten Umschalters (15) und dem Ruhekontakt des zweiten Umschalters (16) zur Begrenzung kurzzeitig auftretender Einschaltströme ein Heißleiter (24) angeordnet ist.

9. Schaltungsanordnung nach einem oder mehreren der vorhergehenden Ansprüche,
dadurch gekennzeichnet, daß die Ansteuereinheit als Logikbaustein und dieser als Mikroprozessor ausgebildet ist und zum quasi rückwirkungsfreien Steuern der Leistungsaufnahme der Lasten (11, 12) folgende Schaltzustände steuert:

   a) Parallelbetrieb beider Lasten (11, 12) mit Versorgungsspannung,
   b) Betrieb nur einer Last (12) mit Versorgungsspannung,

c) Betrieb der einen Last (12) mit Versorgungsspannung und der anderen Last (11) mit 2/3-, 1/3- oder 1/5-Phasenbetrieb,

d) Betrieb wie c) mit gepulsten Phasen,

e) Serienbetrieb beider Lasten (11, 12) mit Versorgungsspannung,

f) Serienbetrieb beider Lasten (11, 12) mit 2/3-, 1/3- oder 1/5-Phasenbetrieb,

g) Betrieb wie f) mit gepulsten Phasen,

h) "Aus"-Betrieb beider Lasten (11, 12),

i) Betrieb der einen Last (12) mit Versorgungsspannung und verzögertes Hinzuschalten der anderen Last (11), auch im 1/3- und 2/3-Phasenbetrieb, und

j) Betrieb beider Lasten (11, 12) im 2/3- oder 1/3-Phasenbetrieb.

10. Schaltungsanordnung nach Anspruch 9, dadurch gekennzeichnet, daß in einem Einschalt-Hochschaltzyklus die Schaltzustände f), e) und a), i) oder j nacheinander zur Erreichung der Maximalleistung angesteuert werden, und zur Absenkung der Leistungsaufnahme mindestens einer der Schaltzustände b) bis j) angesteuert wird.

FIG.1

FIG.2

FIG.3

FIG.4

FIG.5

EP 0 463 687 A2

FIG.6

FIG.7

FIG.8

FIG.9